# EUROPEAN PATENT SPECIFICATION

(11) **EP 3 913 383 B1**
(45) Date of publication and mention of the grant of the patent: **04.10.2023**
(21) Application number: 20176074.1
(22) Date of filing: 22.05.2020
(51) Int. Cl.: G01R 31/28

(54) **METHOD AND SYSTEM FOR DETECTING ANOMALIES IN A SPECTROGRAM, SPECTRUM OR SIGNAL**
VERFAHREN UND SYSTEM ZUR ERKENNUNG VON ANOMALIEN IN EINEM SPEKTROGRAMM, SPEKTRUM ODER SIGNAL
PROCÉDÉ ET SYSTÈME DE DETECTION D'ANOMALIES DANS UN SPECTROGRAMME, UN SPECTRE OU UN SIGNAL

(43) Date of publication of application: 24.11.2021
(73) Proprietor: Rohde & Schwarz GmbH & Co. KG, 81671 München (DE)
(72) Inventor: Guezelarslan, Baris, 81671 München (DE); Hettich, Dominik, 81671 München (DE)
(74) Representative: Prinz & Partner mbB

(56) References cited:
- CA-A1- 2 918 679
- CN-A- 108 181 562
- KR-A- 20200 019 377
- US-A- 5 640 103
- US-A- 5 919 267
- US-A1- 2007 130 491
- US-A1- 2019 197 236

## Description

The invention relates to a method for detecting anomalies in a spectrogram, spectrum or signal as well as to a system for detecting anomalies in a spectrogram, spectrum or signal.

Techniques for detecting anomalies in spectrograms, spectra or signals are known in the art. However, such methods rely on prior knowledge of the anomalies to be detected. However, in many cases there is no prior knowledge of an anomaly that will occur so that prior art approaches cannot be used.

US 2007 / 0 130 491 A1 discloses a method for identifying errors in digital circuits. An actual data output for each current data set pattern of a plurality of current data set patterns is compared to a calculated data output of a corresponding stored data set pattern of a plurality of stored data set patterns to form a plurality of comparisons.

US 5,919,267 A discloses a fault diagnostics system for monitoring the operating condition of a host system with a plurality of neural nets. Each neural net is trained to emulate a certain behavior of the system to be monitored, namely a nominal behavior and several faulty behaviors.

US 2019 / 0 197 236 A1 discloses a method for detecting and correcting anomalies. The method includes predicting normal behavior of a monitored system based on training data that includes only sensor data collected during normal behavior of the monitored system.

US 5,640,103 A discloses a method for detecting a departure from normal operation of an electric motor. A set of normal current measurements is obtained for a motor being monitored. A neural network auto-associator is trained using the set of normal current measurements.

It is the object of the invention to provide a method and a system for detecting anomalies in a spectrogram, spectrum or signal reliably without prior knowledge of the anomalies.

For this purpose, a method for detecting anomalies in a spectrogram, spectrum or signal according to claim 1 is provided.

In order to reliably isolate the anomaly, the filtered data is a denoised version of the measured data.

The predicted data is a predicted version of the measured data and/or filtered data for a predetermined point in the future so that fluctuations in time may taken into consideration by a comparison.

For efficient processing, the first submodule and/or the second submodule comprise a pre-trained artificial neural network, wherein the first submodule and the second submodule have been pre-trained with a training data set free of anomalies.

To allow a simple isolation of anomalies, the first submodule is pre-trained to remove noise and/or anomalies from the measured data.

By creating filtered data and predicted data of the measured data it is possible to obtain a measure for the magnitude of the anomaly by analyzing the deviation of the measured data, the filter data and or the predicted data without any prior knowledge of the anomaly itself. Using the measure for the magnitude of the anomaly, a classification of the measured data towards the presence of anomalies or not can be reliably and quickly performed.

The determination step may be carried out by the comparison submodule.

The measured data, the filtered data and/or the predicted data are, for example, snapshots at a single point in time.

The predetermined amount may be different for different comparisons.

In an embodiment, the measured data, the filtered data and/or the predicted data are a graphical representation of the spectrogram, the spectrum or the signal, in particular at a single point in time or a predefined time interval. Thus, the machine learning submodules are able to process the data efficiently.

The machine learning submodules, in particular the first submodule, may be machine learning modules for visual pattern recognition. For example, the machine learning submodules process only the graphical information of the graphical representation. In particular, they do not make use of the signal underlying the graphical representation itself, e.g. represented as I/Q data.

In an embodiment, the comparison submodule performs the comparison of data by calculating a cost value using a cost function, in particular making use of the difference of the respective data, wherein it is determined that the spectrogram, spectrum or signal comprises an anomaly if the cost value exceeds a predefined threshold. By using a cost function, a resource efficient and fast analysis is achieved.

The cost function may be the same or different for different comparisons.

In an aspect, the comparison submodule obtains a first comparison result, in particular a first cost value, by comparing the filtered data with the measured data and a second comparison result, in particular a second cost value, by comparing the predicted data with the measured data and/or the filtered data. It is determined that the spectrogram, spectrum or a signal comprises an anomaly if either the first comparison result or the second comparison result, both comparison results, or a function of, in particular a sum of the comparison results indicate(s) a deviation above a predetermined amount, in particular the exceed(s) the respective predefined threshold. This way, the detection sensitivity may easily be adjusted using the threshold value.

The predefined threshold may be different for the first cost value than for the second cost value.

For example, the predefined amount, in particular the predefined threshold, is set manually or has been determined by the detection module during training allowing a flexible use.

In a preferred aspect, the training may be based on a graphical representation of a monitored frequency range over time, e.g. spectrograms.

In other words, the first and/or second submodule may be trained to process spectrograms solely graphically.

In an aspect, the first submodule comprises or is an autoencoder reliably generating filtered data without anomalies.

For an efficient prediction, the second submodule may be a recurrent artificial neural network, in particular comprising a Long Short-Term Memory block.

In an aspect, the data of the training data set is a recorded data set, in particular recorded data set that has been pre-processed to be free of anomalies, and/or the training data set is live data allowing a reliable and precise training of the artificial neural networks.

Training may be performed as part of the production process of the system as well as by the customer to adapt the system to the specific needs.

To allow a simple isolation of anomalies, the second submodule is pre-trained to remove noise and/or anomalies from the measured data.

For above purpose, further a system for detecting anomalies in a spectrogram, spectrum or signal is provided, comprising a detection module having a first machine learning submodule, a second machine learning submodule and a comparison submodule, wherein the detection module is configured to carry out a method as explained above.

The features and advantages discussed in context of the method also apply to the system and vice versa.

Naturally, the system, the detection module and its submodules are configured to carry out the method steps discussed in context of the method.

The detection module may comprise an input for receiving the spectrogram, spectrum or signal as measured data by the detection module and/or an output for outputting results.

For example, the system comprises a signal input and a processing unit, in particular wherein the processing unit comprises the detection module reducing complexity.

The signal input may be connected to antenna or a device under test.

In an aspect, the processing unit is configured to generate a graphical representation of a spectrogram, spectrum or a signal based on the signal received at the signal input. This way, the system is self-sufficient.

Further features and advantages will be apparent from the following description as well as the accompanying drawings, to which references made. In the drawings:
- Figure 1 shows a system according to the invention,
- Figure 2 shows a detection module of the system according to Figure 1,
- Figure 3 shows a flowchart of a method according to the invention, and
- Figure 4 shows a flowchart of another embodiment of the method according to the invention.

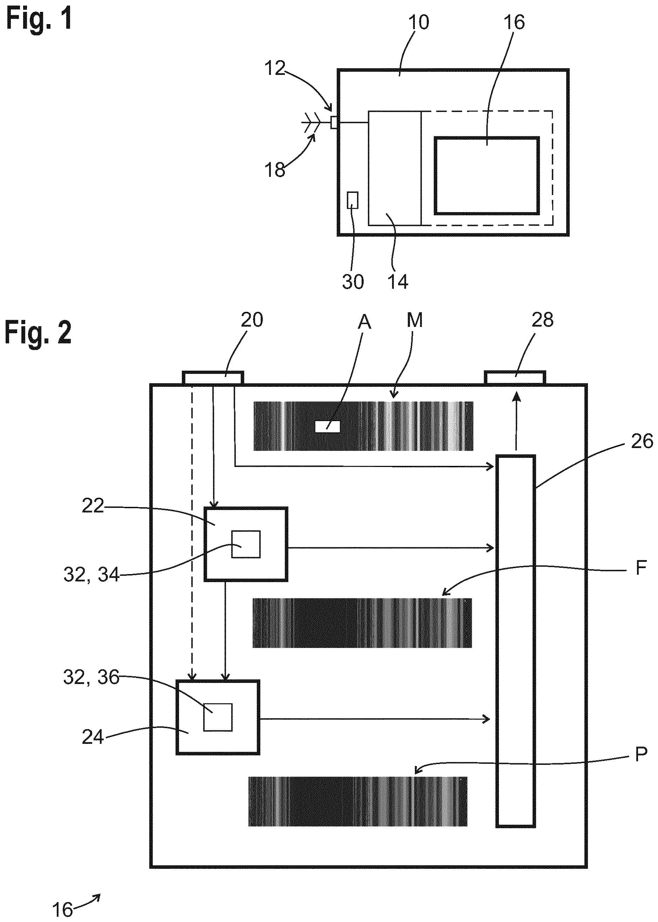

Figure 1 shows very schematically a system 10 for detecting anomalies in a spectrogram, spectrum or signal.

The system 10 may be, for example, a signal analyzer.

The system 10 comprises a signal input 12, a processing unit 14, a detection module 16 and an output device 30.

The signal input 12 may be connected to an antenna 18 for receiving the signals to be analyzed. The detection module 16 may be implemented in the processing unit 14 (illustrated with dashed lines in Figure 1) or is a separate module.

A detection module 16 is shown schematically in more detail in Figure 2.

In the embodiment shown in Figure 2, the data processed by the detection module 16 is a spectrogram, more precisely a graphical representation of a spectrogram.

Of course, the detection module 16 may be also be configured to process spectra or measured signals, in particular graphical representations of spectra or signals.

The detection module 16 comprises an input 20 connected to the processing unit 14 or other parts of the processing unit 14, a first machine learning submodule 22, a second machine learning submodule 24, a comparison submodule 26 and an output 28.

The output 28 of the detection module 16 is connected to the processing unit 14, other parts of the processing unit 14 and/or the output device 30 of the system 10, for example a display.

The first machine submodule 22 comprises an artificial neural network 32 in particular a convolutional artificial neural network configured as an autoencoder 34.

The first submodule 22 has been pre-trained to remove noise and/or anomalies from data.

The second machine learning submodule 24 comprises a recurrent artificial neural network 36 which comprises a Long Short Term Memory (LSTM) block or is configured as a Long Short Term Memory network.

The second submodule 24 has been pre-trained to generate a data set based on the input data set which is a prediction of the spectrogram inputted to the second submodule 24 for a predetermined interval in the future.

The second machine learning submodule 24 has also been pre-trained, in particular with the same training data set or a same kind of training data set as the first submodule 22.

The training data set for the first submodule 22 comprises exclusively data (spectrograms, spectra or signals) not having noise or anomalies so that the autoencoder 34 is trained to output data (spectrograms, spectra or signals) without or lesser noise or anomalies, i.e. denoised data.

Thus, the first submodule 22, i.e. the autoencoder 34, may be regarded as a filter filtering out noise or anomalies from data, preferably purely graphically.

The training data may comprise spectrograms from recorded signal data which have been preprocessed to remove anomalies and/or noise, for example by classical filters. The training set may also be spectrograms generated from live data, i.e. from a very stable and low noise source.

The training data set for training the second submodule 24 may also be free of anomalies and/or noise and comprises a set of input spectrograms and associated correct predicted spectrograms.

Thus, the first submodule 22 and the second submodule 24 may be trained using graphical representations or visual representation of signal data only, i.e. without information about the underlying signal itself (e.g. I/Q data). The submodules will therefore be trained to perform a purely graphical operation to filter or to predict.

Training of the first submodule 22 and the second submodule 24 may be performed as part of the production process of the system 10 as well as by the customer to adapt the system 10 to the specific needs.

The input of the first submodule 22 is connected to the input 20 of the detection module 16, and the second submodule 24 is connected to the output of the first submodule 22. Additionally or alternatively, the second submodule 24 is also connected to the input 20 as indicated with dashed lines in Figure 2.

The input of the comparison submodule 26 is connected to the input 20, the first submodule 22 and the second submodule 24. The output of the comparison submodule 26 is connected to the output 28 of the detection module 16.

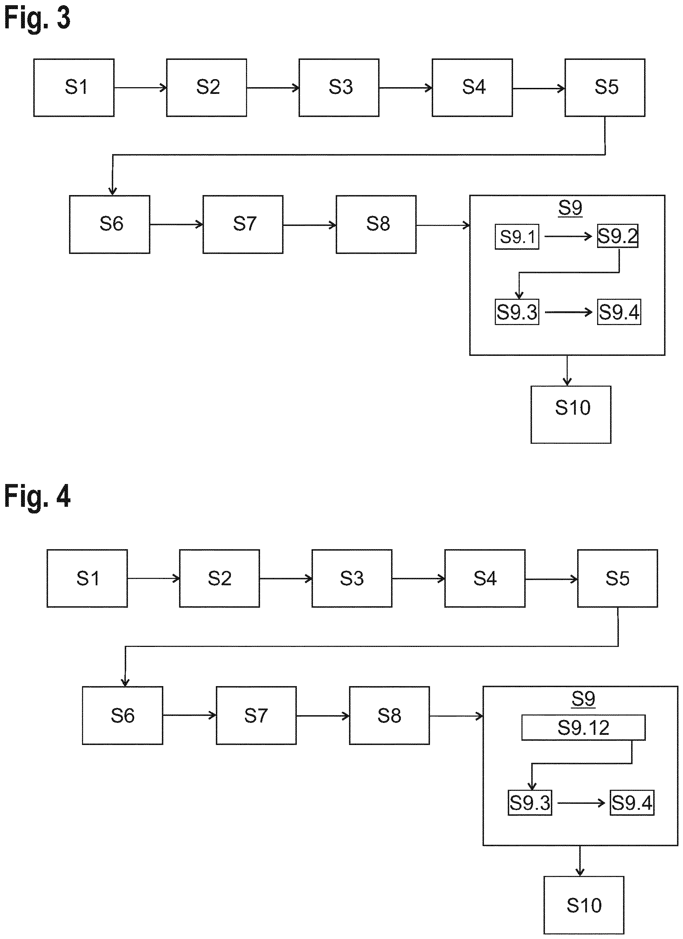

For detecting anomalies A in a spectrogram, spectrum or signal the system 10 performs the method shown in Figure 3.

Firstly, in step S1 the system 10 receives the signal or data to be analyzed via the signal input 12.

This may be, for example, radio signals received by the antenna 18.

In step S2, the processing unit 14 processes the signal to generate a graphical representation of a spectrogram, spectrum or signal of the signal received at the signal input 12. The graphical representation is then, in step S3 transmitted to the input 20 of the detection module 16 and are regarded as the measured data M (see Fig. 2) by the detection module 16.

In Figure 2, only spectrograms are shown to exemplify the method. Of course, the method may also be performed with spectrums or signals instead.

Thus, the detection module 16 receives the measured data M (step S4).

The measured data M is received from the first submodule 22 and processed by the first submodule 22 (step S5). As the first submodule 22 has the architecture of an autoencoder 34 and has been pre-trained to reduce noise and/or anomalies from input data, the first submodule 22 generates filtered data F of the measured data M that does not include noise and anomalies A.

The filtered data F is then transmitted to the second submodule 24 as input data (step S6).

Additionally or alternatively, the second submodule 24 receives the measured data M instead or as well.

In step S7, the second submodule 24 generates predicted data P, i.e. a predicted spectrogram of the evolution of the filtered data F at the predicted point in time, the measured data M or based on both filtered data F and measured data M.

Thus, the predicted data P is a predicted version of the measured data M and/or filtered data F for a predetermined point in the future, i.e. at a predetermined interval in the future.

The measured data M, the filtered data F and the predicted data P are snapshots of a single point in time of the signal or data received at the signal input 12 of the system 10.

In step S8, which of course may also been performed earlier in parts, the measured data M, the filtered data F and the predicted data P are transmitted to the comparison submodule 26.

In step S9 the comparison submodule 26 determines whether or not the measured data M comprises an anomaly A and outputs its result to the output 28 of the detection module 16.

The output device 30 then outputs a signal accordingly (step S10).

In the first embodiment, the comparison submodule 26 comprises two cost functions.

Using the first cost function, the comparison submodule 26 compares the filtered data F with the measured data M yielding a cost value representing the magnitude of the anomalies A that have been removed by the first submodule 22 (step S9.1).

For example, the cost value is the sum of the squared differences of the filtered data F and the measured data M on a pixel-by-pixel basis.

Likewise, the comparison submodule 26 uses the second cost function which may be the same or different from the first cost function i.e. to compare the predicted data P with the measured data M or the filtered data F (Step S9.2).

In step S9.3, the first cost value and the second cost value are compared against predetermined thresholds.

The thresholds may be the same or different for each cost function and the resulting in cost value.

The predetermined thresholds may have been manually set by the user of the system 10.

It is also conceivable, that they have been determined by the detection module 16 during training (aka they have been learned), i.e. that the detection module 16 has been trained with training data comprising measured data M and correct indications of the present of an anomaly A.

For example, the comparison submodule 26 is also an artificial neural network or the submodules 22, 24, 26 are a single artificial neural network so that the threshold may be trained or learned.

The comparison submodule 26 determines in step S9.3 if the first cost value, the second cost value or both cost values are equal to or lie above their respective predetermined thresholds.

Of course, the comparisons (Step S9.2) and determination (Step S9.3) does not have to be performed en bloc but may be performed as soon as possible, i.e. calculating the first cost value may be performed as soon as the filtered data F is obtained without waiting on the results of the second submodule 24.

If so, the comparison submodule 26 determines in step 9.4 that the measured data M have an anomaly A. This result is then transmitted via output 28 of the detection module 16 in a suitable manner.

As the cost values are a measure for the deviation between the compared data, the threshold indicates that the deviation between the data has exceeded a predetermined amount of deviation.

It is also possible that the first and second cost values are not compared separately to thresholds but that a function, for example the sum, of the cost values is obtained and compared against a respective threshold.

When comparing a function of the first and second cost value with a threshold, complex dependencies of the anomalies in frequency and time may be taken into account.

By comparing the measured data M comprising a potential anomaly A with the filtered data F and the predicted data P not comprising the anomaly A due to the operations by the first and/or second submodule 22, 24, the anomaly A is extracted and represented as a cost value which is, at the same time, a measure for the magnitude of the anomaly A.

Using the first submodule 22, frequency anomalies can be determined and by using the second submodule 26 anomalies in time can be detected.

Figure 4 shows a second embodiment of the method according to the invention which corresponds to the first embodiment of the method in most parts. Thus, in the following only the differences are discussed and the same elements and methods steps are references to with the same reference signs.

In the second embodiment of the method, the comparison submodule 26 uses a single, global cost function to determine whether the filtered data F deviates from the measured data M and whether the predicted data P deviates from the measured data M and/or the filtered data F.

Thus, in step S9, the comparison submodule 26 determines a global cost value based on the global cost function in step S9.12. Then, in steps S9.3 and S9.4 the comparison submodule 26 compares the global cost value against a global threshold and determines that an anomaly A is present in the measured data M if the global cost value is equal to or above the global threshold.

## Claims

1. Method for detecting anomalies (A) in a spectrogram, spectrum or signal using a detection module (16), said detection module comprising a first machine learning submodule (22), a second machine learning submodule (24) and a comparison submodule (26), the method comprising the following steps:
a) receiving the spectrogram, spectrum or signal, as measured data (M) by the detection module (16),
b) generating filtered data (F) based on the measured data (M) by the first submodule (22), wherein the filtered data (F) is a denoised version of the measured data (M),
c) comparing the filtered data (F) with the measured data (M) by the comparison submodule (26),
d) generating predicted data (P) based on the measured data (M) and/or the filtered data (F) by the second submodule (24), wherein the predicted data (P) is a predicted version of the measured data (M) and/or filtered data (F) for a predetermined point in the future,
e) comparing the predicted data (P) with the measured data (M) and/or the filtered data (F) by the comparison submodule (26), and
f) determining by the comparison submodule (26), that the spectrogram, spectrum or signal comprises an anomaly (A) if the filtered data (F) deviates from the measured data (M) and/or the predicted data (P) deviates from the measured data (M) and/or the filtered data (F) by at least a predetermined amount,
wherein first submodule (22) comprises a pre-trained artificial neural network (32) and the second submodule (24) comprises a pre-trained artificial neural network (32), wherein the first submodule (22) and the second submodule (24) have been pre-trained with a training data set free of anomalies (A), wherein the first submodule (22) is pre-trained to remove noise and/or anomalies from the measured data (M).

2. Method according to claim 1, **characterized in that** the measured data (M), the filtered data (F) and/or the predicted data (P) are a graphical representation of the spectrogram, the spectrum or the signal, in particular at a single point in time or a predefined time interval.

3. Method according to any one of the preceding claims, **characterized in that** the comparison submodule (26) performs the comparison of data by calculating a cost value using a cost function, in particular making use of the difference of the respective data, wherein it is determined that the spectrogram, spectrum or a signal comprises an anomaly (A) if the cost value exceeds a predefined threshold.

4. Method according to any one of the preceding claims, **characterized in that** the comparison submodule (26) obtains a first comparison result, in particular a first cost value, by comparing the filtered data (F) with the measured data (M) and a second comparison result, in particular a second cost value, by comparing the predicted data (P) with the measured data (M) and/or the filtered data (F),
wherein it is determined that the spectrogram, spectrum or a signal comprises an anomaly (A) if either the first comparison result or the second comparison result, both comparison results, or a function of, in particular a sum of the comparison results indicate(s) a deviation above a predetermined amount, in particular the exceed(s) the respective predefined threshold.

5. Method according to any one of the preceding claims, **characterized in that** in the predefined amount, in particular the predefined threshold, is set manually or has been determined by the detection module (16) during training.

6. Method according to any one of the preceding claims, **characterized in that** the first submodule (22) comprises or is an autoencoder (34).

7. Method according to any one of the preceding claims, **characterized in that** the second submodule (24) is a recurrent artificial neural network (36), in particular comprising a Long Short-Term Memory block.

8. Method according to any one of the preceding claims, **characterized in that** the data of the training data set is a recorded data set, in particular recorded data set that has been pre-processed to be free of anomalies (A), and/or the training data set is live data.

9. Method according to any one of the preceding claims, **characterized in that** the second submodule (24) is pre-trained to remove noise and/or anomalies (A) from the measured data (M).

10. System for detecting anomalies (A) in a spectrogram, spectrum or signal comprising a detection module (16) having a first machine learning submodule (22), a second machine learning submodule (24) and a comparison submodule (26), wherein the detection module (16) is configured to carry out a method according to any one of the preceding claims.

11. System according to claim 10, **characterized in that** the system (10) comprises a signal input (20) and a processing unit (14), in particular wherein the processing unit (14) comprises the detection module (16).

12. System according to claim 11, **characterized in that** the processing unit (14) is configured to generate a graphical representation of a spectrogram, spectrum or signal based on the signal received at the signal input (20).

## Patentansprüche

1. Verfahren zum Erfassen von Anomalien (A) in einem Spektrogramm, einem Spektrum oder einem Signal unter Verwendung eines Erfassungsmoduls (16), das Erfassungsmodul umfassend
ein erstes Maschinenlernuntermodul (22), ein zweites Maschinenlernuntermodul (24) und ein Vergleichsuntermodul (26),
das Verfahren umfassend die folgenden Schritte:
a) Empfangen des Spektrogramms, des Spektrums oder des Signals als Messdaten (M) durch das Erfassungsmodul (16),
b) Erzeugen gefilterter Daten (F) basierend auf den Messdaten (M) durch das erste Untermodul (22), wobei die gefilterten Daten (F) eine entrauschte Version der Messdaten (M) ist,
c) Vergleichen der gefilterten Daten (F) mit den Messdaten (M) durch das Vergleichsuntermodul (26),
d) Erzeugen vorhergesagter Daten (P) basierend auf den Messdaten (M) und/oder den gefilterten Daten (F) durch das zweite Untermodul (24), wobei die vorhergesagten Daten (P) eine vorhergesagte Version der Messdaten (M) und/oder gefilterten Daten (F) für einen zuvor bestimmten Punkt in der Zukunft sind,
e) Vergleichen der vorhergesagten Daten (P) mit den Messdaten (M) und/oder den gefilterten Daten (F) durch das Vergleichsuntermodul (26), und
f) Bestimmen durch das Vergleichsuntermodul (26), dass das Spektrogramm, das Spektrum oder das Signal eine Anomalie (A) umfasst, falls die gefilterten Daten (F) von den Messdaten (M) abweichen und/oder die vorhergesagten Daten (P) um mindestens eine zuvor bestimmte Menge von den Messdaten (M) und/oder den gefilterten Daten (F) abweichen,
wobei das erste Untermodul (22) ein vortrainiertes künstliches neuronales Netzwerk (32) umfasst und das zweite Untermodul (24) ein vortrainiertes künstliches neuronales Netzwerk (32) umfasst, wobei das erste Untermodul (22) und das zweite Untermodul (24) mit einem Trainingsdatensatz, der frei von Anomalien (A) ist, vortrainiert wurden, wobei das erste Untermodul (22) vortrainiert ist, um ein Rauschen und/oder Anomalien aus den Messdaten (M) zu entfernen.

2. Verfahren nach Anspruch 1, **dadurch gekennzeichnet, dass** die Messdaten (M), die gefilterten Daten (F) und/oder die vorhergesagten Daten (P) eine grafische Darstellung des Spektrogramms, des Spektrums oder des Signals, insbesondere zu einem einzigen Zeitpunkt oder einem vordefinierten Zeitintervall, sind.

3. Verfahren nach einem der vorstehenden Ansprüche,
**dadurch gekennzeichnet, dass** das Vergleichsuntermodul (26) den Vergleich von Daten durch Berechnen eines Kostenwerts unter Verwendung einer Kostenfunktion durchführt, insbesondere unter Anwendung der Differenz der jeweiligen Daten, wobei bestimmt wird, dass das Spektrogramm, das Spektrum oder ein Signal eine Anomalie (A) umfasst, falls der Kostenwert einen vordefinierten Schwellenwert überschreitet.

4. Verfahren nach einem der vorstehenden Ansprüche,
**dadurch gekennzeichnet, dass** das Vergleichsuntermodul (26) ein erstes Vergleichsergebnis, insbesondere einen ersten Kostenwert, durch Vergleichen der gefilterten Daten (F) mit den Messdaten (M) und einem zweiten Vergleichsergebnis, insbesondere einen zweiten Kostenwert, durch Vergleichen der vorhergesagten Daten (P) mit den Messdaten (M) und/oder den gefilterten Daten (F), erhält,
wobei bestimmt wird, dass das Spektrogramm, das Spektrum oder ein Signal eine Anomalie (A) umfasst, falls entweder das erste Vergleichsergebnis oder das zweite Vergleichsergebnis, beide Vergleichsergebnisse oder eine Funktion der, insbesondere eine Summe der Vergleichsergebnisse, eine Abweichung über einer zuvor bestimmten Menge, insbesondere die Überschreitung(en) des jeweiligen vordefinierten Schwellenwerts, angibt/angeben.

5. Verfahren nach einem der vorstehenden Ansprüche,
**dadurch gekennzeichnet, dass** in der vordefinierten Menge, insbesondere der vordefinierte Schwellenwert, manuell eingestellt oder durch das Erfassungsmodul (16) während eines Trainings bestimmt wurde.

6. Verfahren nach einem der vorstehenden Ansprüche,
**dadurch gekennzeichnet, dass** das erste Untermodul (22) einen Autoencoder (34) umfasst oder dieser ist.

7. Verfahren nach einem der vorstehenden Ansprüche,
**dadurch gekennzeichnet, dass** das zweite Untermodul (24) ein wiederkehrendes künstliches neuronales Netzwerk (36) ist, insbesondere umfassend einen Block eines langen Kurzzeitgedächtnisses.

8. Verfahren nach einem der vorstehenden Ansprüche,
**dadurch gekennzeichnet, dass** die Daten des Trainingsdatensatzes ein aufgezeichneter Datensatz, insbesondere ein aufgezeichneter Datensatz, sind, der vorverarbeitet wurde, um frei von Anomalien (A) zu sein, und/oder der Trainingsdatensatz live-Daten ist.

9. Verfahren nach einem der vorstehenden Ansprüche,
**dadurch gekennzeichnet, dass** das zweite Untermodul (24) vortrainiert ist, um das Rauschen und/oder die Anomalien (A) aus den Messdaten (M) zu entfernen.

10. System zum Erfassen von Anomalien (A) in einem Spektrogramm, einem Spektrum oder einem Signal, umfassend ein Erfassungsmodul (16), das ein erstes Maschinenlernuntermodul (22), ein zweites Maschinenlernuntermodul (24) und ein Vergleichsuntermodul (26) aufweist, wobei das Erfassungsmodul (16) konfiguriert ist, um ein Verfahren nach einem der vorstehenden Ansprüche durchzuführen.

11. System nach Anspruch 10, **dadurch gekennzeichnet, dass** das System (10) einen Signaleingang (20) und eine Verarbeitungseinheit (14) umfasst, insbesondere wobei die Verarbeitungseinheit (14) das Erfassungsmodul (16) umfasst.

12. System nach Anspruch 11, **dadurch gekennzeichnet, dass** die Verarbeitungseinheit (14) konfiguriert ist, um eine grafische Darstellung eines Spektrogramms, eines Spektrums oder eines Signals basierend auf dem Signal zu erzeugen, das an dem Signaleingang (20) empfangen wird.

## Revendications

1. Procédé de détection d'anomalies (A) dans un spectrogramme, un spectre ou un signal à l'aide d'un module de détection (16), ledit module de détection comprenant
un premier sous-module d'apprentissage machine (22), un second sous-module d'apprentissage machine (24) et un sous-module de comparaison (26),
le procédé comprenant les étapes suivantes :
a) la réception du spectrogramme, du spectre ou du signal, en tant que données mesurées (M) par le module de détection (16),
b) la génération de données filtrées (F) en fonction des données mesurées (M) par le premier sous-module (22), dans lequel les données filtrées (F) sont une version débruitée des données mesurées (M),
c) la comparaison des données filtrées (F) aux données mesurées (M) par le sous-module de comparaison (26),
d) la génération de données prédites (P) en fonction des données mesurées (M) et/ou des données filtrées (F) par le second sous-module (24), dans lequel les données prédites (P) sont une version prédite des données mesurées (M) et/ou des données filtrées (F) pour un point prédéterminé dans l'avenir,
e) la comparaison des données prédites (P) aux données mesurées (M) et/ou aux données filtrées (F) par le sous-module de comparaison (26), et
f) la détermination, par le sous-module de comparaison (26), que le spectrogramme, le spectre ou le signal comprend une anomalie (A) si les données filtrées (F) s'écartent des données mesurées (M) et/ou les données prédites (P) s'écartent des données mesurées (M) et/ou des données filtrées (F) d'au moins une quantité prédéterminée,
dans lequel le premier sous-module (22) comprend un réseau neuronal artificiel pré-entraîné (32) et le second sous-module (24) comprend un réseau neuronal artificiel pré-entraîné (32), dans lequel le premier sous-module (22) et le second sous-module (24) ont été pré-entraînés avec un ensemble de données entraînement exempt d'anomalies (A), dans lequel le premier sous-module (22) est pré-entraîné pour éliminer le bruit et/ou les anomalies des données mesurées (M).

2. Procédé selon la revendication 1, **caractérisé en ce que** les données mesurées (M), les données filtrées (F) et/ou les données prédites (P) sont une représentation graphique du spectrogramme, du spectre ou du signal, en particulier au niveau d'un seul point dans le temps ou d'un intervalle de temps prédéfini.

3. Procédé selon l'une quelconque des revendications précédentes, **caractérisé en ce que** le sous-module de comparaison (26) effectue la comparaison de données en calculant une valeur de coût à l'aide d'une fonction de coût, en particulier en faisant appel à la différence des données respectives, dans lequel il est déterminé que le spectrogramme, le spectre ou un signal comprend une anomalie (A) si la valeur de coût dépasse un seuil prédéfini.

4. Procédé selon l'une quelconque des revendications précédentes, **caractérisé en ce que** le sous-module de comparaison (26) obtient un premier résultat de comparaison, en particulier une première valeur de coût, en comparant les données filtrées (F) aux données mesurées (M) et un second résultat de comparaison, en particulier une seconde valeur de coût, en comparant les données prédites (P) aux données mesurées (M) et/ou aux données filtrées (F),
dans lequel il est déterminé que le spectrogramme, le spectre ou un signal comprend une anomalie (A) si soit le premier résultat de comparaison soit le second résultat de comparaison, les deux résultats de comparaison, ou une fonction, en particulier une somme, des résultats de comparaison indiquent un écart au-dessus d'une quantité prédéterminée, en particulier dépassent le seuil prédéfini respectif.

5. Procédé selon l'une quelconque des revendications précédentes, **caractérisé en ce que** la quantité prédéfinie, en particulier le seuil prédéfini, est réglé(e) manuellement ou a été déterminé(e) par le module de détection (16) pendant l'entraînement.

6. Procédé selon l'une quelconque des revendications précédentes, **caractérisé en ce que** le premier sous-module (22) comprend ou est un auto-encodeur (34).

7. Procédé selon l'une quelconque des revendications précédentes, **caractérisé en ce que** le second sous-module (24) est un réseau neuronal artificiel récurrent (36), comprenant en particulier un bloc de mémoire à long et court terme.

8. Procédé selon l'une quelconque des revendications précédentes, **caractérisé en ce que** les données de l'ensemble de données d'entraînement sont un ensemble de données enregistré, en particulier un ensemble de données enregistré qui a été prétraité pour être exempt d'anomalies (A), et/ou l'ensemble de données d'entraînement est constitué de données en direct.

9. Procédé selon l'une quelconque des revendications précédentes, **caractérisé en ce que** le second sous-module (24) est pré-entraîné pour éliminer le bruit et/ou les anomalies (A) des données mesurées (M).

10. Système de détection d'anomalies (A) dans un spectrogramme, un spectre ou un signal comprenant un module de détection (16) ayant un premier sous-module d'apprentissage machine (22), un second sous-module d'apprentissage machine (24) et un sous-module de comparaison (26), dans lequel le module de détection (16) est configuré pour effectuer un procédé selon l'une quelconque des revendications précédentes.

11. Système selon la revendication 10, **caractérisé en ce que** le système (10) comprend une entrée de signal (20) et une unité de traitement (14), en particulier dans lequel l'unité de traitement (14) comprend le module de détection (16).

12. Système selon la revendication 11, **caractérisé en ce que** l'unité de traitement (14) est configurée pour générer une représentation graphique d'un spectrogramme, d'un spectre ou d'un signal en fonction du signal reçu au niveau de l'entrée de signal (20).
